# EUROPÄISCHE PATENTSCHRIFT

(11) **EP 2 483 847 B1**
(45) Veröffentlichungstag und Bekanntmachung des Hinweises auf die Patenterteilung: **08.04.2020**
(21) Anmeldenummer: 10757773.6
(22) Anmeldetag: 28.09.2010
(51) Int. Cl.: G06K 19/077, G06K 19/073

(54) **CHIPMODUL UND TRAGBARER DATENTRÄGER MIT EINEM CHIPMODUL**
CHIP MODULE AND PORTABLE DATA STORAGE MEDIUM HAVING A CHIP MODULE
MODULE À PUCE ET SUPPORT DE DONNÉES PORTATIF MUNI D'UN MODULE À PUCE

(30) Priorität: 29.09.2009 DE 102009043617
(43) Veröffentlichungstag der Anmeldung: 08.08.2012
(73) Patentinhaber: Giesecke+Devrient Mobile Security GmbH, 81677 München (DE)
(72) Erfinder: BALDISCHWEILER, Michael, 81825 München (DE)
(86) Internationale Anmeldenummer: PCT/EP2010/064339
(87) Internationale Veröffentlichungsnummer: WO 2011/039168

(56) Entgegenhaltungen:
- WO-A1-2004/036649
- DE-B3- 10 326 089
- FR-A1- 2 892 544
- US-A1- 2006 151 361

## Beschreibung

Die Erfindung betrifft ein Chipmodul sowie einen tragbaren Datenträger mit einem Chipmodul.

Chipmodule mit entsprechenden Chips werden heutzutage in tragbaren Datenträgern, insbesondere in Chipkarten, zur elektronischen Speicherung von vertrauenswürdigen Daten, wie z.B. personenbezogenen Daten, sowie zur Durchführung von vertraulichen elektronischen Transaktionen verwendet.

Um sich Zugriff auf die Informationen der in einem Chipmodul gespeicherten Daten zu verschaffen, sind aus dem Stand der Technik verschiedene Angriffe bekannt. Beispielsweise wird versucht, über sog. Lichtangriffe mittels elektromagnetischer Strahlung, insbesondere in der Form von Laserstrahlung, den Betrieb des Chipmoduls zu stören. Basierend auf der Störung kann man mit entsprechenden Analyseverfahren auf dem Chipmodul abgelegte geheime Informationen, wie z.B. kryptographische Schlüssel, ableiten.

Zum Schutz gegen Lichtangriffe sind aus dem Stand der Technik verschiedene Verfahren bekannt. Zum Schutz gegen Angriffe von der Vorderseite, d.h. von der aktiven Seite, des im Chipmodul integrierten Chips werden auf die Vorderseite z.B. Lichtsensoren oder optische Gitter aufgebracht, die Licht reflektieren.

In der Druckschrift DE 60 2004 008 339 T2 wird ein IC-Chip beschrieben, dessen Daten durch elektrisch leitende Elemente auf der Vorderseite des Chips und auf dem Chipsubstrat auf der Rückseite des Chips geschützt werden. Die Elemente sind dabei über induktive Kopplung gekoppelt und ein Angriff, bei dem die leitenden Elemente beschädigt werden, kann durch die Veränderung von elektrischen Parametern der leitenden Elemente detektiert werden. Die in dieser Druckschrift beschriebenen Schutzmaßnahmen sind direkt auf dem Chip bzw. dem Chipsubstrat vorgesehen und erfordern eine aufwändige Anpassung des Herstellungsprozesses des Chips.

In der FR 2 892 544 A1 wird ein Chipmodul vorgeschlagen, welches auf dem Modulträger eine Matrix aus zusätzlichen Leiterbahnen vorgeschlagen, welche al s elektrisch leitendes Element mit dem Chip verbunden wird. Zur Realisierung werden zusätzliche Kontaktflächen auf dem Chip und auch auf dem Modulträger angebracht, um die elektrische Verbindung mit dem Chip herzustellen, wodurch Herstellungsprozesse für den Chip angepasst werden müssen.

In der US 2006/0151361 A1 wird ein Chipmodul vorgeschlagen, welches auf dem Modulträger zusätzliche Kontaktflächen aufweist, mit denen der Chip verbunden wird. Diese zusätzlichen Kontaktflächen werden mit elektrischen Leiterbahnen auf dem Modulträger verbunden, welche zumindest teilweise zwischen Chip und Modulträger angeordnet werden, sodass bei einem Angriff auf die Daten im Chip die elektrischen Leiterbahnen auf dem Modulträger zerstört werden.
Aufgabe der Erfindung ist es deshalb, ein Chipmodul einfach und kostengünstig gegen Angriffe zu schützen.

Diese Aufgabe wird durch das Chipmodul gemäß dem unabhängigen Patentanspruch 1 gelöst. Weiterbildungen der Erfindung sind in den abhängigen Ansprüchen definiert.

Das erfindungsgemäße Chipmodul umfasst einen Modulträger mit einer ersten Seite und einer zweiten Seite sowie elektrisch isolierendem Material zwischen der ersten und zweiten Seite, wobei auf der ersten Seite des Modulträgers ein Chip angeordnet ist und auf der zweiten Seite des Modulträgers eine Anordnung aus einem oder mehreren elektrisch leitenden Kontaktfeldern ausgebildet ist, mit denen der Chip zumindest teilweise verschaltet ist. Auf der ersten Seite des Modulträgers sind ein oder mehrere elektrisch leitende Elemente vorgesehen, welche mit dem Chip zu einer elektrischen Schaltung verschaltet sind. Die elektrische Verbindung des Chips mit dem oder den elektrisch leitenden Elementen kann dabei insbesondere über entsprechende Anschlüsse, z.B. I/O-Pins, auf der Seite des Chips, welche auf dem Modulträger befestigt ist, realisiert werden. Basierend auf den elektrisch leitenden Elementen wird durch eine einfache Modifikation des Modulträgers des Chipmoduls ein effizienter Schutz des Chips vor Angriffen von der Seite der Kontaktfelder des Chipmoduls erreicht. Insbesondere können elektrisch leitende Elemente problemlos auf dem Modulträger aufgebracht werden, ohne dass der Herstellungsprozess des Chips modifiziert werden muss. Durch die Verschaltung des oder der elektrisch leitenden Elemente wird dann die Möglichkeit geschaffen, dass entsprechende Beschädigungen am Modulträger über Veränderungen in der elektrischen Schaltung detektiert werden können.

Gemäß der Erfindung werden das oder die elektrisch leitenden Elemente als elektrisch leitende Schicht auf der ersten Seite des Modulträgers aufgebracht. Solche Schichten können durch technisch einfach realisierbare Herstellungsverfahren erzeugt werden. Der Begriff der Schicht ist dabei weit zu verstehen und umfasst nicht zwangsläufig eine durchgehende Fläche, sondern kann auch eine aufgebrachte Struktur, beispielsweise in der Form von Leiterbahnen, umfassen.

Gemäß der Erfindung ist zumindest ein elektrisch leitendes Element als elektrisch leitende Fläche auf der ersten Seite des Modulträgers gegenüberliegend zu einem Massepotential-Kontaktfeld auf der zweiten Seite des Modulträgers ausgebildet, so dass durch das Massepotential-Kontaktfeld, die elektrisch leitende Fläche und das dazwischen liegende elektrisch isolierende Material des Modulträgers ein Kondensator in der mit dem Chip verschalteten elektrischen Schaltung gebildet wird. Hierdurch wird eine besonders effiziente Detektion von Angriffen erreicht, da sich bereits bei einer Beschädigung des Massepotential-Kontaktfelds die elektrischen Eigenschaften des Kondensators verändern und basierend darauf ein Angriff erkannt werden kann. Die elektrisch leitende Fläche ist dabei vorzugsweise über einen Anschluss des Chips, z.B. ein I/O-Pin auf der Rückseite des Chips, und eine elektrische Verschaltung im Chip mit einem Widerstand und einem Versorgungspotential-Kontaktfeld elektrisch verbunden.

Gemäß der Erfindung umfassen das oder die elektrisch leitenden Elemente eine oder mehrere Leiterbahnen auf der ersten Seite des Modulträgers, welche den Chip jeweils mit einem Kontaktfeld auf der zweiten Seite des Modulträgers verbinden. Hierdurch kann auf einfache Weise ein Angriff erkannt werden, der zu einer Beschädigung der Leiterbahnen und somit zu einem Kommunikationsverlust führt. Vorzugsweise sind die Leiterbahnen mäanderförmig auf der ersten Seite des Modulträgers ausgebildet, so dass eine gute Überdeckung der Rückseite des Chips mit Leiterbahnen und somit ein vollflächiger Schutz erreicht wird.

In einer besonders bevorzugten Ausführungsform sind als Leiterbahnen zumindest drei Leiterbahnen vorgesehen, wobei eine erste Leiterbahn den Chip mit einem I/O-Kontaktfeld verbindet, eine zweite Leiterbahn den Chip mit einem CLK-Kontaktfeld verbindet und eine dritte Leiterbahn den Chip mit einem RESET-Kontaktfeld verbindet. Diese Arten von Kontaktfeldern sowie entsprechende Anschlüsse an dem Chip sind hinlänglich aus dem Stand der Technik bekannt und dienen zum Datenaustausch mit dem Chip bzw. zur Zuführung eines Taktsignals bzw. RESET-Signals zum Chip.

In einer weiteren Ausführungsform des erfindungsgemäßen Chipmoduls ist zumindest ein elektrisch leitendes Element als Spule auf der ersten Seite des Modulträgers ausgebildet. Vorzugsweise ist dabei die Spule an einem Ende mit einem Massepotential-Kontaktfeld elektrisch verbunden und an dem anderen Ende über einen Anschluss des Chips, insbesondere ein I/O-Pin auf der Rückseite des Chips, und eine elektrische Verschaltung im Chip mit einem Widerstand und einem Versorgungspotential-Kontaktfeld elektrisch verbunden. Wird durch einen Angriff die Spule beschädigt, kann dieser Angriff über die Veränderung des Induktivitätswerts der Spule detektiert werden.

In einer weiteren Ausführungsform des erfindungsgemäßen Chipmoduls bildet zumindest ein elektrisch leitendes Element einen elektrischen Widerstand, dessen eine Seite mit einem Massepotential-Kontaktfeld elektrisch verbunden ist und dessen andere Seite über einen Anschluss des Chips, z.B. über ein I/O-Pin auf der Rückseite des Chips, und eine elektrische Verschaltung im Chip mit einem Versorgungspotential-Kontaktfeld elektrisch verbunden ist. Durch Veränderung des Widerstands können auf diese Weise Angriffe detektiert werden. Der Widerstand ist dabei vorzugsweise als leitfähiges Kunststoffsubstrat auf der ersten Seite des Modulträgers ausgebildet, insbesondere als mäanderförmiges Kunststoffsubstrat.

Gemäß der Erfindung ist im Chip des Moduls ein Mittel zur Überwachung der elektrischen Schaltung vorgesehen, zu der das oder die elektrisch leitenden Elemente mit dem Chip verschaltet sind. Dieses Mittel überwacht den Betrieb des Chipmoduls und detektiert eine Abweichung der elektrischen Schaltung von einem Normalzustand, d.h. einem Zustand, bei dem keine Veränderungen von außen am Chipmodul vorgenommen wird. Basierend auf dieser Detektion können dann durch den Chip entsprechende Gegenmaßnahmen eingeleitet werden, beispielsweise können vertrauliche Informationen gelöscht werden.

Gemäß der Erfindung umfasst das Mittel zur Überwachung der elektrischen Schaltung eine Messeinrichtung zur Messung einer oder mehrerer elektrischer Eigenschaften der elektrischen Schaltung, wobei die Messeinrichtung eine Abweichung des oder der gemessenen Eigenschaften von einem oder mehreren vorbestimmten Werten detektiert. Diese Variante der Erfindung kommt insbesondere bei der Ausbildung der elektrisch leitenden Elemente als Kondensator bzw. Spule bzw. Widerstand in Betracht. In diesem Fall misst die Messeinrichtung entsprechende Parameter, welche auf Kapazitäten bzw. Induktivitäten bzw. Widerständen beruhen. Dabei wurden entsprechende Normwerte vorab, beispielsweise bei der Personalisierung des Chipmoduls, gemessen und im Chip abgespeichert. Sobald eine ausreichend große Abweichung der elektrischen Parameter von den Normwerten auftritt, wird ein Angriff detektiert und es können wiederum entsprechende Gegenmaßnahmen eingeleitet werden, beispielsweise können vertrauenswürdige Informationen auf dem Chip gelöscht werden.

In einer weiteren Variante des erfindungsgemäßen Verfahrens umfasst das Mittel zur Überwachung der elektrischen Schaltung eine Einrichtung zur Detektion eines Kommunikationsverlusts zwischen Chip und einem oder mehreren Kontaktfeldern auf der zweiten Seite des Modulträgers. Diese Variante der Erfindung kommt insbesondere bei der Ausbildung der elektrisch leitenden Elemente als Leiterbahnen in Betracht und hat den Vorteil, dass explizit keine Messung von elektrischen Parametern durchgeführt werden muss, sondern allein anhand eines Kommunikationsverlusts aufgrund einer Beschädigung der Leiterbahnen ein Angriff festgestellt werden kann. Daraufhin können wieder entsprechende Gegenmaßnahmen eingeleitet werden, beispielsweise das Löschen von vertrauenswürdigen Informationen.

Neben dem oben beschriebenen Chipmodul umfasst die Erfindung ferner einen tragbaren Datenträger, insbesondere eine Chipkarte, welcher das erfindungsgemäße Chipmodul umfasst.

Ausführungsbeispiele der Erfindung werden nachfolgend anhand der beigefügten Figuren detailliert beschrieben:
Es zeigen:
- Fig. 1: eine Draufsicht auf die Kontaktfelder eines Chipmoduls gemäß einer Ausführungsform der Erfindung;
- Fig. 2: eine Schnittansicht durch das Chipmodul der Fig. 1; und
- Fig. 3: ein elektrisches Ersatzschaltbild zur Verdeutlichung der Verschaltung eines in dem Chipmodul der Fig. 1 bzw. Fig. 2 ausgebildeten Kondensators.

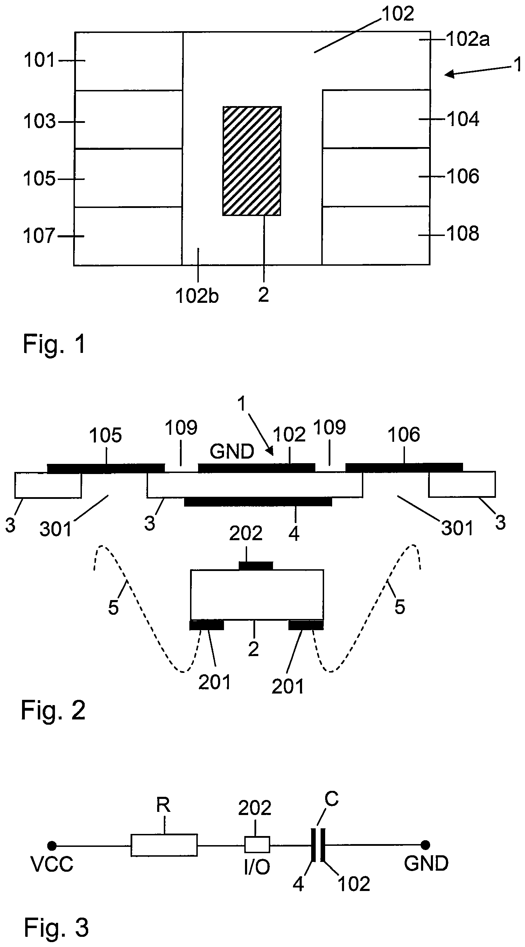

Das in Fig. 1 in Draufsicht gezeigte Chipmodul dient zur Anbringung in einem entsprechenden Chipkartenkörper, um hierdurch eine Chipkarte zu bilden. Es umfasst an seiner Oberseite eine an sich bekannte Anordnung 1 aus einer Mehrzahl von Kontaktfeldern 101, 102, ..., 108. Die Kontaktfeld-Anordnung ist dabei auf einen (nicht aus Fig. 1 ersichtlichen) Modulträger auf dessen Oberseite aufgebracht, und auf der Unterseite des Modulträgers ist der Chip 2 vorgesehen, der in Fig. 1 schematisch als schraffiertes Rechteck angedeutet ist. Der Chip ist vorzugsweise ein Mikroprozessorchip mit entsprechendem Controller. Über geeignetes Bonding ist der Chip mit entsprechenden Kontaktfeldern der Kontaktfeld-Anordnung 1 verbunden. Dabei kann die Verbindung beispielsweise über Bonddrähte bzw. über andere Bonding-Verfahren, z.B. MCM-Bonding, hergestellt werden. In der Ausführungsform der Fig. 1 dient das Kontaktfeld 101 als Versorgungspotential-Anschluss zur Zuführung der Versorgungsspannung VCC an den Chip 2. Demgegenüber stellt das Kontaktfeld 102 den Massepotential-Anschluss dar.

Bis auf das Kontaktfeld 102 sind alle Kontaktfelder rechteckförmig ausgebildet sind. Das Kontaktfeld 102 weist demgegenüber eine L-förmige Struktur mit einem kurzen Schenkel 102a und einem langen Schenkel 102b in der Form eines Mittelstegs der Kontaktfeld-Anordnung 1 auf. Der Chip 2 ist unterhalb dieses Mittelstegs 102 angeordnet. Die restlichen Kontaktfelder 103 bis 108 können verschieden belegt sein, wobei sicherzustellen ist, dass immer ein RESET-Feld zum Zurücksetzen des Chips, ein Takteingang in der Form eines CLK-Felds sowie ein zur bidirektionalen Datenübertragung vorgesehenes I/O-Feld vorhanden ist. In der Ausführungsform der Fig. 1 ist das Feld 103 das RESET-Kontaktfeld, das Feld 105 das CLK-Kontaktfeld und das Feld 106 das I/O-Kontaktfeld. Jedes dieser Felder ist mit entsprechenden Anschlüssen des Chips durch Bonding verbunden.

Bei herkömmlichen Chipmodulen ist kein Schutz gegen Lichtangriffe von der Oberseite der Kontaktfeld-Anordnung 1 vorgesehen. Insbesondere können die Kontaktfelder im Bereich des Chips aufgebrochen werden, und mit einer starken Lichtquelle, beispielsweise Laserdioden, kann der Chip dann unbefugt analysiert werden, um hierdurch vertrauliche Daten, wie z.B. kryptographische Schlüssel, auszulesen. Um solche unbefugten Lichtangriffe zu vermeiden, ist in der hier beschriebenen Ausführungsform eines Chipmoduls eine elektrisch leitende Schicht auf der Unterseite des Modulträgers vorgesehen. Die Ansicht der Fig. 2, welche einen senkrecht durch die Kontaktfelder 105 und 106 sowie den Chip 2 verlaufenden Schnitt durch das Modul der Fig. 1 darstellt, zeigt diesen Aufbau. Man erkennt in Fig. 2 insbesondere den aus elektrisch isolierendem Basismaterial hergestellten Modulträger 3 mit einer leitenden Schicht 4 auf seiner Unterseite und mit entsprechenden Öffnungen zur Kontaktierung der Kontaktfelder auf seiner Oberseite. In Fig. 2 sind dabei zwei Öffnungen 301 gezeigt, welche eine Kontaktierung hin zu dem Kontaktfeld 105 bzw. 106 ermöglichen. Man erkennt in Fig. 2 ferner, dass die einzelnen Kontaktfelder auf der Oberseite voneinander beabstandet und somit elektrisch isoliert sind. Insbesondere wird ersichtlich, dass zwischen dem Kontaktfeld 105 bzw. 106 elektrisch isolierende Abstände 109 hin zu dem Mittelsteg des auf Massepotential liegenden Kontaktfelds 102 vorgesehen sind.

Fig. 2 zeigt ferner den Chip 2, dessen Rückseite an der Unterseite des Modulträgers 3 angebracht wird. Die aktive Seite des Chips, welche in Fig. 2 seine Unterseite darstellt, umfasst eine Mehrzahl von Anschlüssen zur Verbindung mit entsprechenden Kontaktfeldern. Insbesondere sind dabei Anschlüsse zur Verbindung mit dem RESET-Kontaktfeld, dem CLK-Kontaktfeld und dem I/O-Kontaktfeld der Kontaktfeld-Anordnung 1 vorgesehen. Die Anschlüsse des Chips sind in Fig. 2 beispielhaft durch zwei Kontaktpins 201 angedeutet, welche über Bonddrähte 5, die gestrichelt wiedergegeben sind, mit Kontaktfeldern verbunden werden.

Wie oben erwähnt, ist auf der Unterseite des Modulträgers 3 ein elektrisch leitendes Element in der Form einer leitenden Schicht 4 vorgesehen. Diese Schicht ist gegenüberliegend zum Mittelsteg 102 der Kontaktfeld-Anordnung 1 auf der Oberseite angeordnet. Die Schicht wird mit dem Chip 2 über einen entsprechenden Anschluss 202 in der Form eines I/O-Pins verschaltet. Dabei ist das I/O-Pin 202 im Gegensatz zu den Pins 201 auf der Rückseite des Chips vorgesehen, welche an dem Modulträger befestigt wird und somit auf die elektrisch leitende Schicht 4 zuweist. Durch den Mittelsteg 102 der Kontaktfeld-Anordnung 1, die elektrisch leitende Schicht 4 sowie das dazwischen liegende elektrisch isolierende Material des Modulträgers 3 wird ein Kondensator gebildet, der über den Mittelsteg 102 auf Massepotential GND liegt. Der Kondensator ist dabei über den Anschluss 202 mit dem Chip derart verschaltet, dass über einen Widerstand im Chip und einen entsprechenden Chipanschluss, der über einen Bonddraht hin zu dem Kontaktfeld 101 führt, eine Verbindung zum Versorgungspotential VCC geschaffen wird. Es wird somit unter Zwischenschaltung der elektrisch leitenden Schicht 4 eine elektrische Schaltung gebildet, deren Ersatzschaltbild in Fig. 3 gezeigt ist.

Man erkennt in Fig. 3 insbesondere, dass die Versorgungsspannung VCC über einen chipinternen Widerstand R und von dort über das I/O-Pin 202 einem Kondensator C zugeführt wird, der durch die elektrisch leitende Schicht 4 sowie das Kontaktfeld 102 gebildet ist. Dieser Kondensator ist über das Kontaktfeld 102 mit dem Massepotential GND verbunden. Es wird auf diese Weise die Möglichkeit geschaffen, elektrische Eigenschaften dieser Schaltung während des Betriebs des Chipmoduls zu überwachen. Insbesondere besteht die Möglichkeit, einen Schwingkreis mit Hilfe des RC-Glieds der Fig. 3 zu erzeugen und Veränderungen in der Resonanzfrequenz des Schwingkreises festzustellen. Ebenso kann der Lade- bzw. Entladevorgang des Kondensators C vermessen werden. Da die Kapazität des Kondensators auf dem Modulträger sehr klein ist, können effizient basierend auf der Veränderung elektrischer Kenngrößen Beschädigungen erkannt werden, welche zur Durchführung entsprechender Lichtangriffe, z.B. durch Bohren von Löchern in den Modulträger, an dem Chipmodul vorgenommen werden. Es wird somit eine einfache Möglichkeit geschaffen, um Lichtangriffe von der Oberseite des Chipmoduls über die Veränderung elektrischer Kenngrößen der Schaltung der Fig. 3 zu erkennen.

Anstatt eine elektrisch leitende Schicht 4 als Fläche eines Kondensators C auszubilden, gibt es in weiteren Beispielen, die nicht der Erfindung entsprechen, auch noch andere Möglichkeiten, um mittels elektrisch leitender Elemente auf der Unterseite des Modulträgers Lichtangriffe zu erfassen. Beispielsweise können auf der Unterseite des Modulträgers mäanderförmige Leiterbahnen aufgebracht sein, welche Anschlüsse des Chips mit den entsprechenden Kontaktfeldern für I/O, CLK bzw. RESET verbinden. Werden diese Bahnen bei einem Angriff beschädigt, ist keine Verbindung mehr mit dem Controller innerhalb des Chips möglich. Ebenso besteht die Möglichkeit, auf der Unterseite des Modulträgers eine Leiterbahn in Spulenform aufzubringen. Auf diese Weise kann ein RL-Schwingkreis aufgebaut werden. Dieser Schwingkreis ist vorzugsweise analog zu dem Schaltbild der Fig. 3 verschaltet, d.h. in dem Schaltbild wird der Kondensator C durch eine entsprechende Spule ersetzt. Kommt es bei der Durchführung eines Angriffs aufgrund des Bohrens von Löchern in dem Modulträger zu einer Beschädigung der Spule, kann dies wiederum durch eine Veränderung entsprechender Kenngrößen der Schaltung detektiert werden.

In einem weiteren Beispiel ist als elektrisch leitende Schicht ein Kunststoffsubstrat, beispielsweise wiederum in Mäanderform, auf der Unterseite des Modulträgers aufgebracht. Dieses Substrat hat einen spezifischen Widerstand in Abhängigkeit von der Größe seiner Fläche. Somit wird ein chipindividueller Widerstand pro Modul hergestellt. Das Substrat kann gegebenenfalls auch entsprechende Haft- bzw. Klebeeigenschaften aufweisen, um den Chip auf dem Modul zu halten. Die eine Seite des Substrats wird dabei über eine entsprechende Kontaktierung direkt, d.h. ohne Zwischenschaltung des Chips, mit der Masse GND verbunden. Die andere Seite des Substrats wird wiederum über ein I/O-Pin mit dem Chip derart verschaltet, dass der Widerstand des Substrats an das Versorgungspotential geführt wird. Durch eine entsprechende Widerstandsmessung während des Betriebs des Chips kann auf diese Weise eine Beschädigung des Substrats über eine Widerstandsänderung und hierdurch ein entsprechender Angriff auf das Chipmodul erfasst werden.

Wie oben dargelegt, wird zur Detektion eines Angriffs auf das Chipmodul der Betrieb des Chipmoduls überwacht. In den Ausführungsformen, bei denen über die elektrisch leitende Schicht 4 ein Kondensator bzw. eine Spule bzw. ein Widerstand gebildet ist, werden dabei - vorzugsweise bei der Personalisierung des Chipmoduls - eine oder mehrere entsprechende Kenngrößen der die elektrische Schicht beinhaltenden Schaltung gemessen. Diese gemessenen Kenngrößen werden als Referenzwerte in dem Chipmodul abgespeichert. Im Betrieb des Chipmoduls wird anschließend - vorzugsweise in unregelmäßigen Abständen - während der Abarbeitung der Chipkommandos durch Messungen überprüft, ob die Kenngrößen, beispielsweise in der Form entsprechender C-, L- bzw. R-Werte, unter Berücksichtigung eines vorgegebenen Toleranzbereichs noch mit den Referenzwerten übereinstimmen. Wird der Toleranzbereich verlassen, liegt eine absichtliche Beschädigung des Modulträgers vor, was entsprechend detektiert wird. Im oben beschriebenen Beispiel, bei welchem der Chip über mäanderförmige Leiterbahnen mit den Kontaktfeldern CLK, RST bzw. I/O verbunden ist, braucht keine Überprüfung elektrischer Kenngrößen durchgeführt werden, da eine entsprechende Beschädigung der Leiterbahnen automatisch zu einem Kommunikationsverlust führt und auf diese Weise detektiert werden kann. Wird im Betrieb des Chipmoduls eine entsprechende Veränderung einer Kenngröße bzw. ein Kommunikationsverlust erfasst, können entsprechende Gegenmaßnahmen zur Verhinderung des Angriffs eingeleitet werden, beispielsweise können im Chip abgespeicherte geheime Daten gelöscht werden.

Die im Vorangegangenen beschriebene Ausführungsform eines erfindungsgemäßen Chipmoduls weist eine Reihe von Vorteilen auf. Insbesondere wird ohne die Modifikation des Chips selbst eine einfache Möglichkeit zur Detektion von Lichtangriffen von der Oberseite des Chipmoduls geschaffen. Dies wird in einfacher Weise durch eine elektrisch leitende Schicht auf der Unterseite des Modulträgers erreicht, die in geeigneter Weise mit dem Chip zu einer elektrischen Schaltung verschaltet ist. Dabei können Veränderungen in der elektrischen Schaltung aufgrund einer Beschädigung des Chipmoduls auf der Seite des Kontaktfelds erfasst werden und somit Lichtangriffe auf die Rückseite des Chips erkannt werden.

## Patentansprüche

1. Chipmodul, umfassend einen Modulträger (3) mit einer ersten Seite und einer zweiten Seite sowie elektrisch isolierendem Material zwischen der ersten und zweiten Seite,
wobei auf der ersten Seite ein Chip (2) angeordnet ist und auf der zweiten Seite eine Anordnung (1) aus einem oder mehreren elektrisch leitenden Kontaktfeldern (101,102, ..., 108) ausgebildet ist, mit denen der Chip (2) zumindest teilweise verschaltet ist,
auf der ersten Seite des Modulträgers (3) ein oder mehrere elektrisch leitende Elemente (4) vorgesehen sind, welche mit dem Chip (2) zu einer elektrischen Schaltung verschaltet sind,
der Chip (2) ein Mittel zur Überwachung der elektrischen Schaltung umfasst,
wobei das Mittel im Betrieb des Chipmoduls eine Abweichung der elektrischen Schaltung von einem Normalzustand detektiert und wobei
das Mittel zur Überwachung der elektrischen Schaltung eine Messeinrichtung zur Messung einer oder mehrerer elektrischer Eigenschaften der elektrischen Schaltung umfasst, wobei die Messeinrichtung eine Abweichung des oder der gemessenen Eigenschaften von einem oder mehreren vorbestimmten Werten detektiert, **dadurch gekennzeichnet, dass**
das elektrisch leitende Element (4) als Spule oder Kondensator (C) ausgebildet ist,
wobei das elektrisch leitende Element (4) als elektrisch leitende Schicht auf der ersten Seite des Modulträgers (3) aufgebracht ist,
wobei das elektrisch leitende Element (4) als elektrisch leitende Fläche auf der ersten Seite des Modulträgers (3) gegenüberliegend zu einem Massepotential-Kontaktfeld (102) auf der zweiten Seite des Modulträgers (3) ausgebildet ist, so dass durch das Massepotential-Kontaktfeld (102), die elektrisch leitende Fläche und das dazwischen liegende isolierende Material des Modulträgers (3) ein Kondensator (C) in der elektrischen Schaltung gebildet wird.

2. Chipmodul nach Anspruch 1, **dadurch gekennzeichnet, dass** die elektrisch leitende Fläche über einen Anschluss (202) des Chips (2) und eine elektrische Verschaltung im Chip (2) mit einem Widerstand (R) und einem Versorgungspotential-Kontaktfeld (101) elektrisch verbunden ist.

3. Chipmodul nach einem der vorhergehenden Ansprüche, **dadurch gekennzeichnet, dass** das oder die elektrisch leitenden Elemente (4) eine oder mehrere Leiterbahnen auf der ersten Seite des Modulträgers (3) umfassen, welche den Chip (2) jeweils mit einem Kontaktfeld (101, 102, ..., 108) auf der zweiten Seite des Modulträgers (3) verbinden.

4. Chipmodul nach Anspruch 3, **dadurch gekennzeichnet, dass** das oder die Leiterbahnen mäanderförmig auf der ersten Seite des Modulträgers (3) ausgebildet sind.

5. Chipmodul nach Anspruch 3 oder 4, **dadurch gekennzeichnet, dass** zumindest drei Leiterbahnen vorgesehen sind, wobei
- eine erste Leiterbahn den Chip (2) mit einem I/O-Kontaktfeld (106) verbindet;
- eine zweite Leiterbahn den Chip (2) mit einem CLK-Kontaktfeld (105) verbindet;
- eine dritte Leiterbahn den Chip (2) mit einem RESET-Kontaktfeld (103) verbindet.

6. Chipmodul nach einem der vorhergehenden Ansprüche, **dadurch gekennzeichnet, dass** das elektrisch leitende Element (4) als Spule auf der ersten Seite des Modulträgers (3) ausgebildet ist.

7. Chipmodul nach Anspruch 6, **dadurch gekennzeichnet, dass** die Spule an einem Ende mit einem Massepotential-Kontaktfeld (102) elektrisch verbunden ist und an dem anderen Ende über einen Anschluss (202) des Chips (2) und eine elektrische Verschaltung im Chip (2) mit einem Widerstand (R) und einem Versorgungspotential-Kontaktfeld (101) elektrisch verbunden ist.

8. Chipmodul nach einem der vorhergehenden Ansprüche, **dadurch gekennzeichnet, dass** ein weiteres elektrisch leitendes Element (4) einen Widerstand bildet, dessen eine Seite mit einem Massepotential-Kontaktfeld (102) elektrisch verbunden ist und dessen andere Seite über einen Anschluss (202) des Chips (2) und eine elektrische Verschaltung im Chip (2) mit einem Versorgungspotential-Kontaktfeld (101) verbunden ist.

9. Chipmodul nach Anspruch 8, **dadurch gekennzeichnet, dass** der Widerstand als leitfähiges Kunststoffsubstrat auf der ersten Seite des Modulträgers (3) ausgebildet ist, insbesondere als mäanderförmiges Kunststoffsubstrat.

10. Chipmodul nach einem der vorhergehenden Ansprüche, **dadurch gekennzeichnet, dass** die elektrische Verbindung des Chips (2) mit dem oder den elektrisch leitenden Elementen (4) über entsprechende Anschlüsse auf der Seite des Chips, welche auf dem Modulträger befestigt ist, realisiert wird.

11. Chipmodul nach Anspruch 1, **dadurch gekennzeichnet, dass** das elektrische Element mit einem Widerstand im Chip (2) zu einem Schwingkreis verschaltet ist.

12. Chipmodul nach Anspruch 1, **dadurch gekennzeichnet, dass** das Mittel zur Überwachung der elektrischen Schaltung eine Einrichtung zur Detektion eines Kommunikationsverlusts zwischen Chip (2) und einem oder mehreren Kontaktfeldern (101, 102, ..., 108) auf der zweiten Seite des Modulträgers (3) umfasst.

13. Tragbarer Datenträger, insbesondere Chipkarte, **dadurch gekennzeichnet, dass** der Datenträger ein Chipmodul nach einem der vorhergehenden Ansprüche umfasst.

## Claims

1. A chip module, comprising a module carrier (3) with a first side and a second side, and electrically insulating material between the first and second sides,
wherein a chip (2) is arranged on the first side and an arrangement (1) of one or several electroconductive contact fields (101, 102, ..., 108) with which the chip (2) is at least partially interconnected is formed on the second side,
on the first side of the module carrier (3) one or several electroconductive elements (4) are provided which are interconnected with the chip (2) to form an electrical circuit,
the chip (2) comprises a means for monitoring the electrical circuit,
wherein the means detects a deviation of the electrical circuit from a normal state during operation of the chip module and wherein
the means for monitoring the electrical circuit comprises a measuring device for measuring one or several electrical properties of the electrical circuit, wherein the measuring device detects a deviation of the measured property or properties from one or several predetermined values
**characterized in that**
the electroconductive element (4) is configured as a coil or capacitor (C),
wherein the electroconductive element (4) is applied as an electroconductive layer to the first side of the module carrier (3),
wherein the electroconductive element (4) is configured as an electroconductive area on the first side of the module carrier (3) opposite a ground-potential contact field (102) on the second side of the module carrier (3), so that a capacitor (C) is formed in the electrical circuit by the ground-potential contact field (102), the electroconductive area and the interposed insulating material of the module carrier (3).

2. The chip module according to claim 1, **characterized in that** the electroconductive area is electrically connected to a resistor (R) and a supply-potential contact field (101) via a connector (202) of the chip (2) and an electrical interconnection in the chip (2).

3. The chip module according to any of the preceding claims, **characterized in that** the electroconductive element or elements (4) comprise one or several conductor paths on the first side of the module carrier (3), which connect the chip (2) in each case to a contact field (101, 102, ..., 108) on the second side of the module carrier (3).

4. The chip module according to claim 3, **characterized in that** the conductor path or paths are configured in a meandering shape on the first side of the module carrier (3).

5. The chip module according to claim 3 or 4, **characterized in that** at least three conductor paths are provided, wherein
- a first conductor path connects the chip (2) to an I/ O contact field (106);
- a second conductor path connects the chip (2) to a CLK contact field (105);
- a third conductor path connects the chip (2) to a RESET contact field (103).

6. The chip module according to any of the preceding claims, **characterized in that** the electroconductive element (4) is configured as a coil on the first side of the module carrier (3).

7. The chip module according to claim 6, **characterized in that** the coil is electrically connected at one end to a ground-potential contact field (101) and is electrically connected at the other end to a resistor (R) and a supply-potential contact field (101) via a connector (202) of the chip (2) and an electrical interconnection in the chip (2).

8. The chip module according to any of the preceding claims, **characterized in that** a further electroconductive element (4) forms a resistor, one side of which is electrically connected to a ground-potential contact field (102) and the other side of which is connected to a supply-potential contact field (101) via a connector (202) of the chip (2) and an electrical interconnection in the chip (2).

9. The chip module according to claim 8, **characterized in that** the resistor is configured as a conductive plastic substrate on the first side of the module carrier (3), in particular as a plastic substrate of a meandering shape.

10. The chip module according to any of the preceding claims, **characterized in that** the electrical connection of the chip (2) is realized with the electroconductive element or elements (4) via corresponding connectors on the side of the chip which is attached to the module carrier.

11. The chip module according to claim 1, **characterized in that** the electrical element is interconnected with a resistor in the chip (2) to form an oscillating circuit.

12. The chip module according to claim 1, **characterized in that** the means for monitoring the electrical circuit comprises a device for detecting a loss of communication between the chip (2) and one or several contact fields (101, 102, ..., 108) on the second side of the module carrier (3).

13. A portable data carrier, in particular a chip card, **characterized in that** the data carrier comprises a chip module according to any of the preceding claims.

## Revendications

1. Module puce comprenant un support de module (3) ayant une première face et une deuxième face ainsi que du matériau électriquement isolant entre la première et la deuxième face,
cependant que, sur la première face, une puce (2) est agencée, et que, sur la deuxième face, un agencement (1) d'un ou de plusieurs champs de contact (101, 102, ...,108) électriquement conducteurs avec lesquels la puce (2) est au moins partiellement connectée est réalisé,
sur la première face du support de module (3), un ou plusieurs éléments (4) électriquement conducteurs sont prévus, lesquels sont connectés avec la puce (2) de manière à engendrer un circuit électrique,
la puce (2) comprend un moyen de surveillance du circuit électrique,
cependant que le moyen, pendant le fonctionnement du module puce, détecte une divergence du circuit électrique par rapport à un état normal, et cependant que
le moyen de surveillance du circuit électrique comprend un dispositif de mesure pour la mesure d'une ou de plusieurs propriétés électriques du circuit électrique, cependant que le dispositif de mesure détecte une divergence de la ou des propriétés mesurées par rapport à une ou plusieurs valeurs prédéterminées,
**caractérisé en ce que**
l'élément (4) électriquement conducteur est réalisé sous forme de bobine ou de condensateur (C),
cependant que l'élément (4) électriquement conducteur est appliqué sous forme de couche électriquement conductrice sur la première face du support de module (3),
cependant que l'élément (4) électriquement conducteur est réalisé sous forme de surface électriquement conductrice sur la première face du support de module (3) à l'opposé d'un champ de contact de potentiel de masse (102) situé sur la deuxième face du support de module (3), de telle sorte que, par le champ de contact de potentiel de masse (102), la surface électriquement conductrice et le matériau électriquement isolant du support de module (3) se trouvant entre ces derniers, un condensateur (C) est créé dans le circuit électrique.

2. Module puce selon la revendication 1, **caractérisé en ce que** la surface électriquement conductrice est, par l'intermédiaire d'un raccordement (202) de la puce (2) et d'une connexion électrique dans la puce (2), électriquement reliée à une résistance (R) et à un champ de contact (101) de potentiel d'alimentation.

3. Module puce selon une des revendications précédentes, **caractérisé en ce que** le ou les éléments (4) électriquement conducteurs comprennent une ou plusieurs pistes conductrices sur la première face du support de module (3), lesquelles relient la puce (2) respectivement à un champ de contact (101, 102, ...,108) sur la deuxième face du support de module (3).

4. Module puce selon la revendication 3, **caractérisé en ce que** la ou les pistes conductrices sont réalisées en méandres sur la première face du support de module (3).

5. Module puce selon la revendication 3 ou 4, **caractérisé en ce qu'**au moins trois pistes conductrices sont prévues, cependant que
- une première piste conductrice relie la puce (2) avec un champ de contact I/O (106) ;
- une deuxième piste conductrice relie la puce (2) avec un champ de contact CLK (105) ;
- une troisième piste conductrice relie la puce (2) avec un champ de contact RESET (103) ;

6. Module puce selon une des revendications précédentes, **caractérisé en ce que** l'élément (4) électriquement conducteur est réalisé sous forme de bobine sur la première face du support de module (3).

7. Module puce selon la revendication 6, **caractérisé en ce que** la bobine est, à une extrémité, reliée à un champ de contact de potentiel de masse (102), et est, à l'autre extrémité, par l'intermédiaire d'un raccordement (202) de la puce (2) et d'une connexion électrique dans la puce (2), électriquement reliée à une résistance (R) et à un champ de contact (101) de potentiel d'alimentation.

8. Module puce selon une des revendications précédentes, **caractérisé en ce qu'**un autre élément (4) électriquement conducteur constitue une résistance dont une face est électriquement reliée à un champ de contact de potentiel de masse (102), et dont l'autre face est, par l'intermédiaire d'un raccordement (202) de la puce (2) et d'une connexion électrique dans la puce (2), électriquement reliée à un champ de contact (101) de potentiel d'alimentation.

9. Module puce selon la revendication 8, **caractérisé en ce que** la résistance est réalisée sous forme de substrat en matière plastique conducteur sur la première face du support de module (3), en particulier sous forme de substrat en matière plastique en méandres.

10. Module puce selon une des revendications précédentes, **caractérisé en ce que** la liaison électrique de la puce (2) avec le ou les éléments (4) électriquement conducteurs est réalisée par l'intermédiaire de raccordements correspondants sur la face de la puce qui est fixée au support de module.

11. Module puce selon la revendication 1, **caractérisé en ce que** l'élément électrique est connecté avec une résistance dans la puce (2) de manière à engendrer un circuit oscillant.

12. Module puce selon la revendication 1, **caractérisé en ce que** le moyen de surveillance du circuit électrique comprend un dispositif de détection d'une perte de communication entre la puce (2) et un ou plusieurs champs de contact (101, 102, ...,108) sur la deuxième face du support de module (3).

13. Support de données portable, en particulier carte à puce, **caractérisé en ce que** le support de données comprend un module puce selon une des revendications précédentes.
